(19) Europäisches Patentamt
European Patent Office
Office européen des brevets

(11) **EP 3 504 795 B1**

(12) **FASCICULE DE BREVET EUROPEEN**

(45) Date de publication et mention
de la délivrance du brevet:
**14.10.2020 Bulletin 2020/42**

(51) Int Cl.:
*H03K 3/57* *(2006.01)* *H05B 41/26* *(2006.01)*

(21) Numéro de dépôt: **17768179.8**

(86) Numéro de dépôt international:
**PCT/FR2017/052271**

(22) Date de dépôt: **24.08.2017**

(87) Numéro de publication internationale:
**WO 2018/037192 (01.03.2018 Gazette 2018/09)**

(54) **GENERATEUR D'IMPULSIONS ELECTRIQUES**

STROMPULSGENERATOR

ELECTRICAL PULSE GENERATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.08.2016 FR 1657935**

(43) Date de publication de la demande:
**03.07.2019 Bulletin 2019/27**

(73) Titulaire: **Clarteis**
**06560 Valbonne - Sophia Antipolis (FR)**

(72) Inventeur: **BHOSLE, Sounil**
**31600 Lherm (FR)**

(74) Mandataire: **Brevalex**
**95, rue d'Amsterdam**
**75378 Paris Cedex 8 (FR)**

(56) Documents cités:
**EP-A1- 2 389 047 WO-A2-2009/022804**

**Description**

**DOMAINE TECHNIQUE**

La présente concerne un générateur d'impulsions électriques destiné à alimenter un dispositif à décharge à barrière diélectrique.

**ART ANTÉRIEUR**

Les décharges à barrière diélectrique représentent une technologie particulièrement intéressante pour générer un plasma.

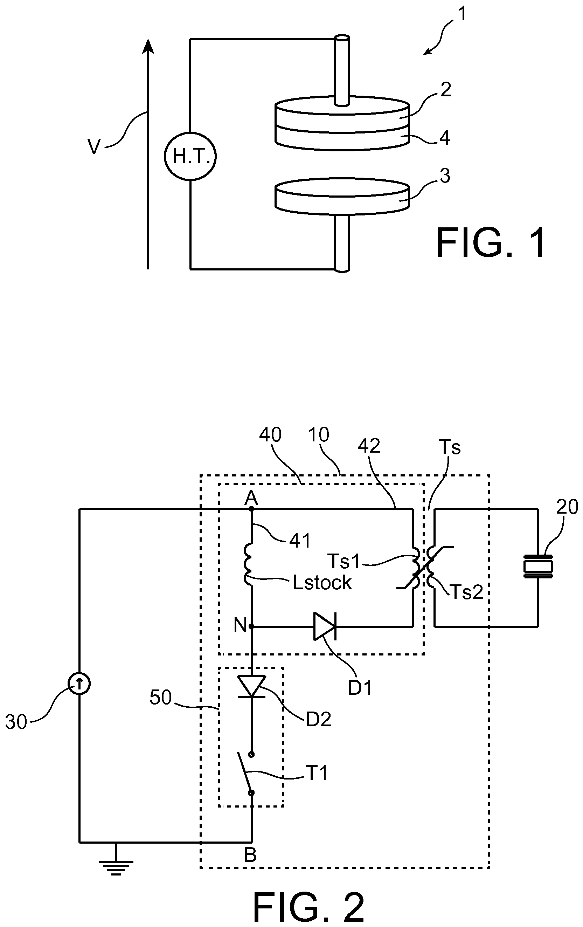

A cet égard, la figure 1 représente un exemple de dispositif 1 adapté pour la génération d'une décharge à barrière diélectrique au sein d'un gaz placé entre deux électrodes 2 et 3 (nous notons cependant que la génération de décharges à barrière diélectrique n'est pas limitée au dispositif représenté à la figure 1). Le dispositif 1 est, en outre, doté d'un matériau diélectrique 4, dans le cas présent, au contact d'une des deux électrodes 2 et 3. Ainsi, dès lors que le gaz est soumis à une tension V, supérieure à sa tension de claquage Vc et imposée par les deux électrodes 2 et 3, une décharge à barrière diélectrique peut être observée. Cependant, lors de la décharge, le matériau diélectrique, isolant par nature, bloque les charges, et crée un champ électrique s'opposant au champ électrique imposé par les deux électrodes 2 et 3, conférant ainsi un caractère transitoire à la décharge. Ce caractère transitoire permet de générer un plasma dans un état dit « hors d'équilibre thermodynamique » qui trouve nombre d'applications, à température proche de l'ambiante et dans une large gamme de pressions incluant la pression atmosphérique. Notamment, de tels plasmas peuvent être exploités pour le traitement de surfaces, des procédés physico-chimiques ou encore produire des rayonnements lumineux. L'homme du métier trouvera une description des applications potentielles des décharges à barrière diélectrique dans le document [1] cité à la fin de la description.

Cependant, pour produire et entretenir une décharge à barrière diélectrique, il est nécessaire de mettre en œuvre un générateur permettant d'imposer une tension V, supérieure à la tension de claquage Vc du gaz, de manière périodique. En effet, la décharge à barrière diélectrique étant par nature un phénomène transitoire, la décharge doit être réamorcée de manière périodique de sorte que le plasma produit apparait stable en moyenne.

Par ailleurs, on observe un intérêt grandissant d'appliquer aux décharges à barrière diélectrique une tension V de forme impulsionnelle (ci-après nommé impulsion électrique) plutôt que de forme sinusoïdale (par tension impulsionnelle, on entend une tension présentant un front montant et un descendant présentant des pentes abruptes).

Le document [2] cité à la fin de la description présente un générateur adapté pour la génération d'impulsions électriques périodiques. Le document [2] présente une topologie originale qui permet d'envoyer une impulsion de tension brutale, à travers la décharge d'un condensateur dans la décharge à barrière diélectrique, puis d'un circuit de récupération de l'énergie non-consommée dans la décharge. Cette topologie permet de générer des formes d'ondes régulières et dépourvues d'oscillations parasites.

Ce dispositif n'est cependant pas satisfaisant.

En effet, le courant important généré lors de la décharge n'est limité que par des éléments parasites du circuit, notamment, la résistance du bobinage et l'inductance de fuite du générateur. Ces éléments sont difficiles à maîtriser.

Par ailleurs, le générateur proposé, en fonctionnement, met en contact de manière brutale une capacité de stockage et la décharge à barrière diélectrique. Il en résulte une pointe de courant importante traversant interrupteur de puissance qui doit être dimensionné pour supporter ladite pointe de courant.

En outre, le circuit de récupération d'énergie, pourvu de diodes haute tension, doit pouvoir laisser passer un courant de récupération qui peut être important. De telles diodes haute tension sont des éléments coûteux qui limitent ainsi leur intérêt pour de telles applications.

Enfin, le générateur comprend des commutateurs de puissance, généralement, soumis à des courants importants lors des cycles de décharge qui induisent de fortes pertes lors de leur commutation. Ces pertes par commutation rendent la commande des commutateurs compliquée et peuvent nécessiter de surdimensionner lesdits commutateurs. Le document EP2389047A1 divulgue un générateur d'impulsions électriques destiné à alimenter un dispositif à décharge à barrière diélectrique, le générateur comprenant une inductance destinée à stocker une énergie fournie, pendant une phase de charge, par une source de tension continue à deux bornes d'alimentation du générateur, et transférer ladite énergie au dispositif à décharge à barrière diélectrique pendant une phase de décharge par l'intermédiaire d'un transformateur, le générateur comprenant: un agencement en série d'un premier et d'un second circuits connectés en un nœud du générateur, le premier circuit comprenant deux branches parallèles, l'une des deux branches comprenant l'inductance, et l'autre branche comprenant, en série, une diode reliée par sa cathode au circuit primaire du transformateur, le circuit secondaire du transformateur étant connecté au dispositif à décharge à barrière diélectrique, le second circuit comprenant un interrupteur commandé dont la fermeture et l'ouverture commandent, respectivement, les phases de charge et de décharge.

Un but de la présente invention est alors de proposer un générateur d'impulsions électriques destiné à alimenter un dispositif à décharge à barrière diélectrique, et permettant de limiter les pertes par commutation observées dans les générateurs connus de l'état de la technique.

Un autre but de la présente invention est de proposer un générateur d'impulsions électriques compact et léger, ne nécessitant pas le surdimensionnement de ces éléments constitutifs, et permettant ainsi d'atteindre un coût de fabrication compatible avec les exigences industrielles.

## EXPOSÉ DE L'INVENTION

Les buts de l'invention sont ainsi en partie atteints par un générateur d'impulsions électriques destiné à alimenter un dispositif à décharge à barrière diélectrique, le générateur comprenant une inductance destinée à stocker une énergie fournie, pendant une phase de charge, par une source de tension continue à deux bornes d'alimentation du générateur, et transférer ladite énergie au dispositif à décharge à barrière diélectrique pendant une phase de décharge par l'intermédiaire d'un transformateur élévateur, le générateur comprenant en outre :

- un agencement en série d'un premier et d'un second circuits connectés en un nœud N du générateur,
- le premier circuit comprenant deux branches parallèles, l'une des deux branches comprenant l'inductance, et l'autre branche comprenant, en série, une diode reliée par son anode au nœud N, et par sa cathode au circuit primaire du transformateur élévateur, le circuit secondaire du transformateur élévateur étant destiné à être connecté au dispositif à décharge à barrière diélectrique,
- le second circuit comprenant un interrupteur commandé dont la fermeture et l'ouverture commandent, respectivement, les phases de charge et de décharge.

Selon un mode de réalisation, le second circuit comprend en outre une diode électriquement connectée en série avec l'interrupteur commandé, et reliée par son anode au nœud N.

Selon un mode de réalisation, le transformateur élévateur comprend également un noyau magnétique, le générateur à impulsions électriques comprend en outre le dispositif à décharge à barrière diélectrique, ledit dispositif à barrière diélectrique comprenant un gaz adapté pour générer une décharge à barrière diélectrique dès lors qu'une tension V, supérieure à une tension de fonctionnement $V_D$ du dispositif à décharge à barrière diélectrique, est imposée audit dispositif, de sorte que la décharge à barrière diélectrique génère une première variation de flux magnétique, prédéterminée par la tension de fonctionnement $V_D$, au travers du noyau magnétique, le noyau magnétique étant dimensionné pour se saturer magnétiquement dès lors qu'une variation de flux magnétique, supérieure à la première variation de flux magnétique, le traverse.

Selon un mode de réalisation, le générateur comprend en outre un module de commande adapté pour générer un signal de commande Sc destiné à commander l'ouverture et la fermeture de l'interrupteur commandé.

Selon un mode de réalisation, le module de commande comprend des moyens de comparaison d'un courant Istock traversant l'inductance avec un courant de référence Iref, le signal de commande du module de commande commandant l'ouverture de l'interrupteur contrôlé dès lors que le courant Istock est supérieur au courant Iref.

Selon un mode de réalisation, les moyens de comparaison comprennent un premier comparateur.

Selon un mode de réalisation, le module de commande comprend une bascule D comprenant une sortie Sc destinée à envoyer le signal de commande Sc à l'interrupteur commandé.

Selon un mode de réalisation, le module de commande est, en outre, adapté pour générer un signal de commande Sc de fermeture de l'interrupteur commandé dès réception d'un signal externe de commande, avantageusement, le signal externe de commande est un signal d'horloge H1 en créneau, et un signal de commande Sc de fermeture est généré sur chaque front montant du signal d'horloge H1.

Selon un mode de réalisation, le signal externe de commande est envoyé sur une entrée C de la bascule D, la comparaison du courant Istock avec le courant de référence Iref est envoyée sur l'entrée D et RST# de la bascule D.

Selon un mode de réalisation, le module de commande comprend, en outre, un moyen de détermination du signe de la tension au nœud N, le module de commande étant adapté pour générer un signal de commande Sc commandant la fermeture de l'interrupteur commandé dès lors que la tension au nœud N est négative.

Selon un mode de réalisation, le moyen de détermination du signe de la tension est un second comparateur.

Selon un mode de réalisation, le moyen de détermination du signe de la tension est connecté à l'entrée C de la bascule D, le moyen de détermination du signe de la tension étant adapté pour envoyer un état haut à l'entrée C de la bascule D dès lors que la tension V(ad1) au nœud N est négative.

Selon un mode de réalisation, le module de commande comprend une porte logique OU interposée entre le moyen de détermination du signe de la tension et l'entrée C de la bascule D, la sortie du moyen de détermination du signe de la tension étant connectée à une entrée de la porte logique OU, et un générateur d'amorçage étant connecté à une seconde entrée de la porte logique OU, le générateur d'amorçage étant adapté pour générer un état dit « haut » en entrée de la porte logique OU.

Selon un mode de réalisation, le module de commande comprend en outre une porte logique ET interposée entre les moyens de comparaison et l'entrée D de la bascule D, la porte logique comprenant une première entrée alimentée par les moyens de comparaison et une seconde entrée alimentée par un signal, la porte logique ET alimentant l'entrée D de la bascule D, la porte logique ET étant adaptée pour envoyer un signal haut à l'entrée D dès lors que le courant Istock est supérieur au courant de référence Iref et que le signal est haut également, et un signal ENABLE bas permettant d'arrêter le générateur d'impulsions électriques.

## BRÈVE DESCRIPTION DES DESSINS

D'autres caractéristiques et avantages apparaîtront dans la description qui va suivre du générateur d'impulsions électriques selon l'invention, donnés à titre d'exemples non limitatifs, en référence aux dessins annexés dans lesquels :

- la figure 1 est une représentation schématique d'un dispositif à décharge à barrière diélectrique susceptible d'être alimenté par le générateur d'impulsions électriques selon l'invention,
- la figure 2 est une représentation d'une topologie simplifiée du générateur à impulsions électriques selon un mode de réalisation avantageux de l'invention,

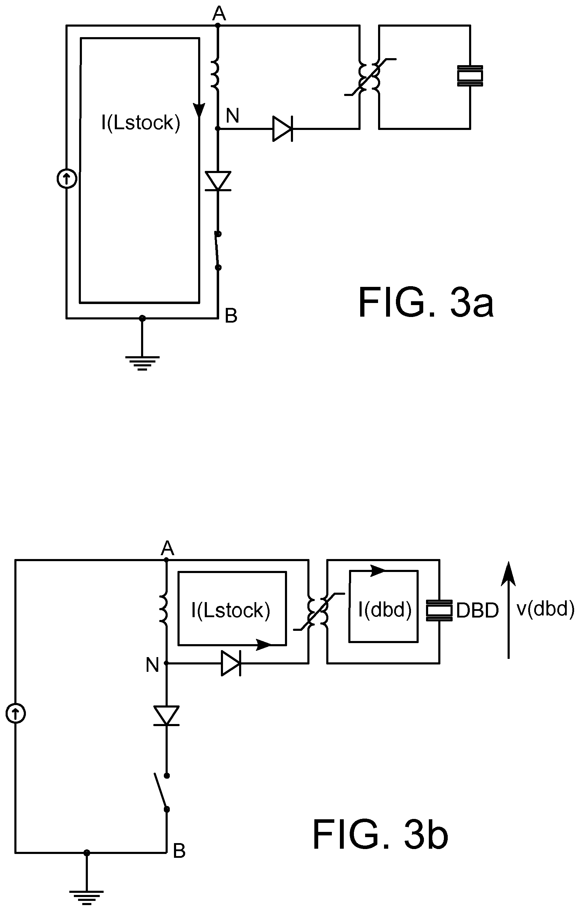

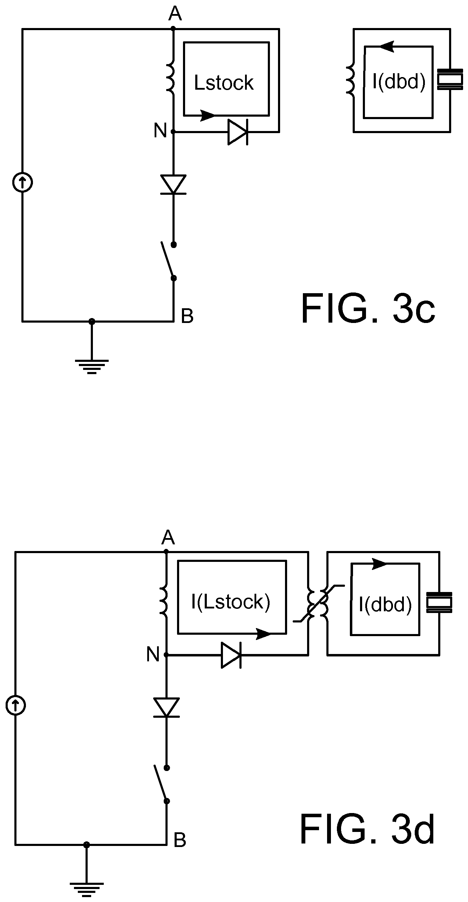

- les figures 3a, 3b, 3c et 3d sont des représentations schématiques des boucles de courant circulant dans le générateur à impulsions électriques selon l'invention, plus particulièrement, les figures 3a, 3b, 3c et 3d illustrent, respectivement, le sens des boucles de courant lors des première, seconde, troisième et quatrième séquences,

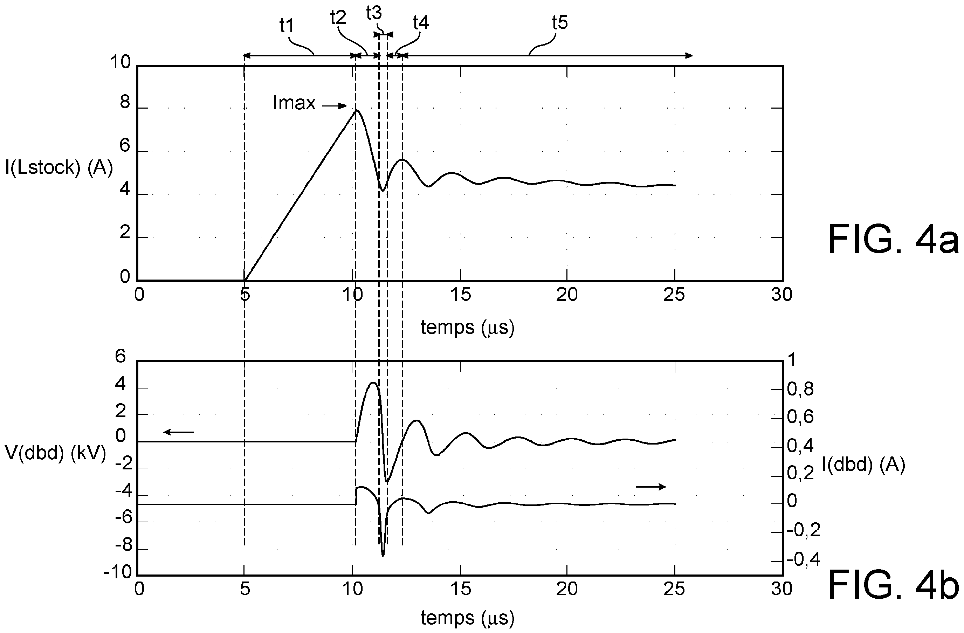

- la figure 4a est une représentation graphique obtenue par simulation numérique de l'intensité du courant traversant l'inductance Lstock (sur l'axe vertical) en fonction du temps (axe horizontal) lors du déroulement des quatre séquences de fonctionnement du générateur à impulsions électriques, selon l'invention, sur une impulsion unique,
- la figure 4b une représentation graphique, obtenue par simulation numérique, de la tension V(dbd) (axe vertical de gauche) et de l'intensité du courant I(dbd) (axe vertical de droite) en fonction du temps (axe horizontal) d'un dispositif à décharge à barrière diélectrique alimenté par une impulsion unique délivrée par le générateur à impulsions électriques selon l'invention,

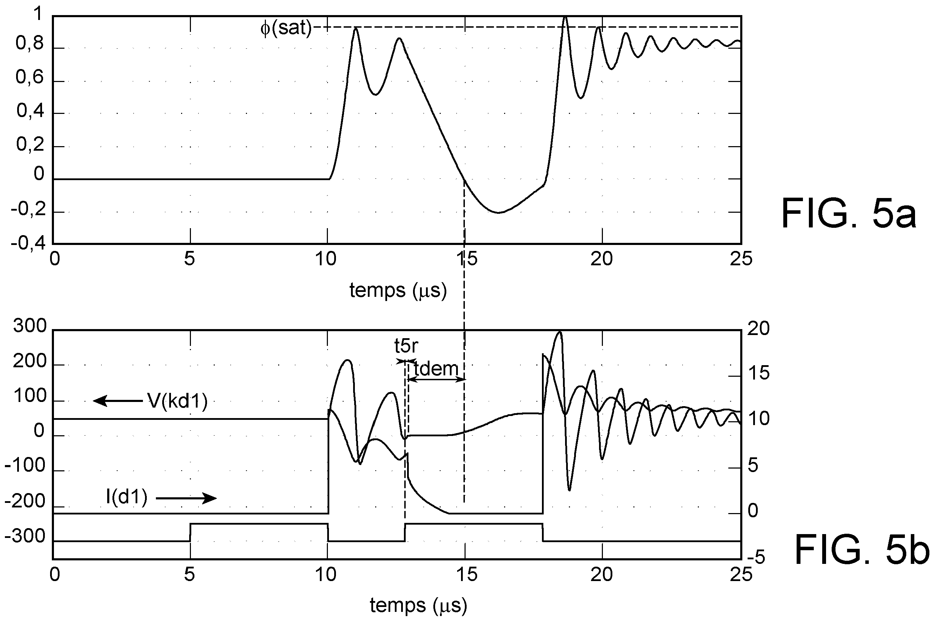

- la figure 5a représente l'évolution du flux magnétique (selon l'axe vertical) dans le transformateur élévateur, comprenant un noyau magnétique, en fonction du temps (le flux magnétique étant un indicateur de l'état magnétique dudit transformateur) dans le contexte d'une fermeture de l'interrupteur commandé T1 pour une tension Vkd1 négative, $\phi$sat représentant le flux de saturation du noyau magnétique du transformateur,
- la figure 5b représente l'évolution de la tension Vkd1 et le courant traversant la diode D1 dans le contexte d'une fermeture de l'interrupteur commandé T1 pour une tension Vkd1 négative,

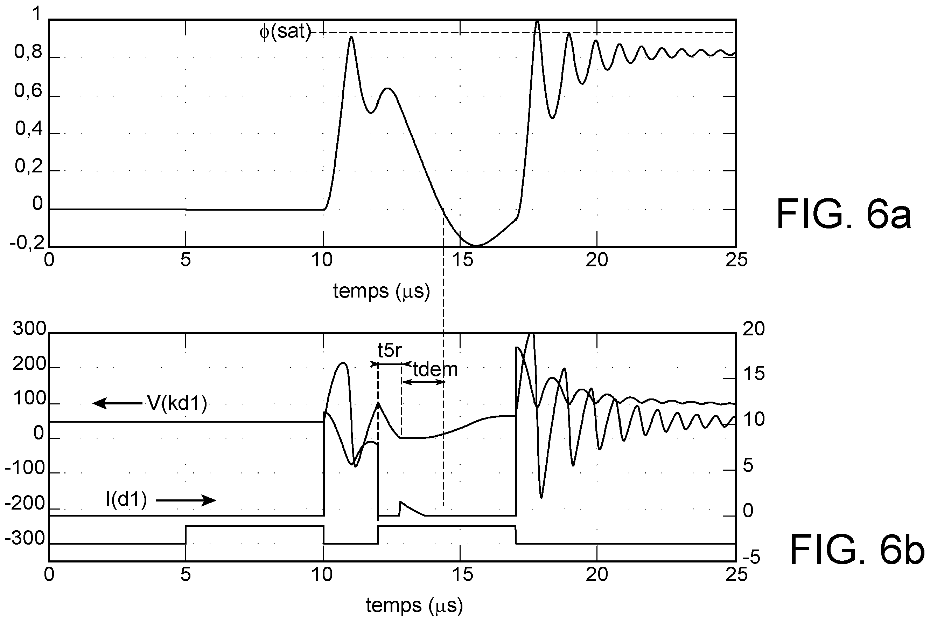

- la figure 6a représente l'évolution du flux magnétique (selon l'axe vertical) dans le transformateur élévateur, comprenant un noyau magnétique, en fonction du temps (le flux magnétique étant un indicateur de l'état magnétique dudit transformateur) dans le contexte d'une fermeture de l'interrupteur commandé T1 pour une tension Vkd1 positive, $\phi$sat représentant le flux de saturation du noyau magnétique du transformateur,
- la figure 6b représente l'évolution de la tension Vkd1 et le courant I(d1) traversant la diode D1 dans le contexte d'une fermeture de l'interrupteur commandé T1 pour une tension Vkd1 positive,

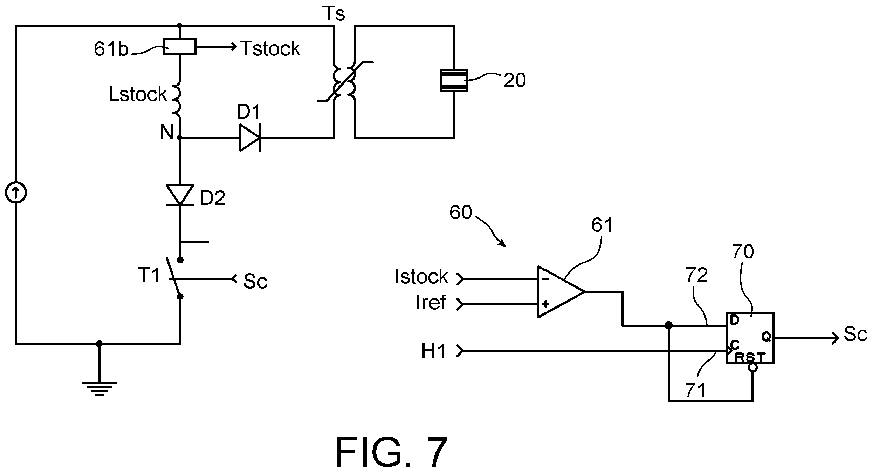

- la figure 7 est une représentation schématique de la topologie d'un module de commande destiné à commander l'interrupteur commandé T1 selon une stratégie de commande en courant limité,

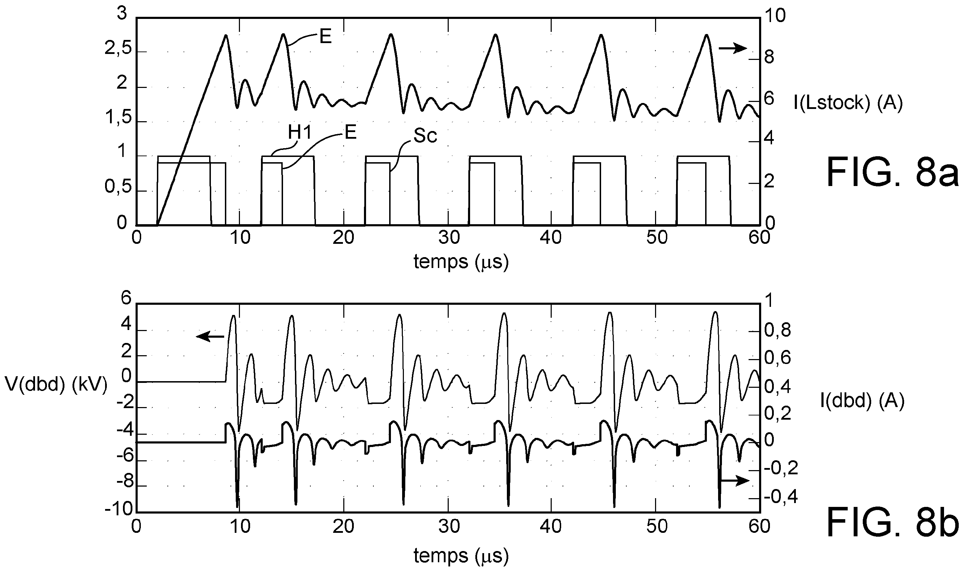

- la figure 8a est une représentation graphique, d'une simulation numérique du fonctionnement du générateur à impulsions électriques selon l'invention, dans le contexte d'une stratégie de commande en courant limité, le graphique représentant le courant Istock traversant l'inductance Lstock (axe vertical droite), le signal d'horloge H1 (axe vertical gauche) et le signal de commande Sc généré par la bascule D (axe vertical gauche) et envoyé à l'interrupteur commandé T1, en fonction du temps (axe horizontal),
- la figure 8b est une représentation graphique, d'une simulation numérique du fonctionnement du générateur à impulsions électriques selon l'invention, dans le contexte d'une stratégie de commande en courant limité, le graphique représentant le courant I(dbd) (axe vertical droite) traversant le dispositif à décharge à barrière diélectrique, ainsi que la tension V(dbd) (axe vertical gauche) aux bornes dudit dispositif, en fonction du temps (axe horizontal),

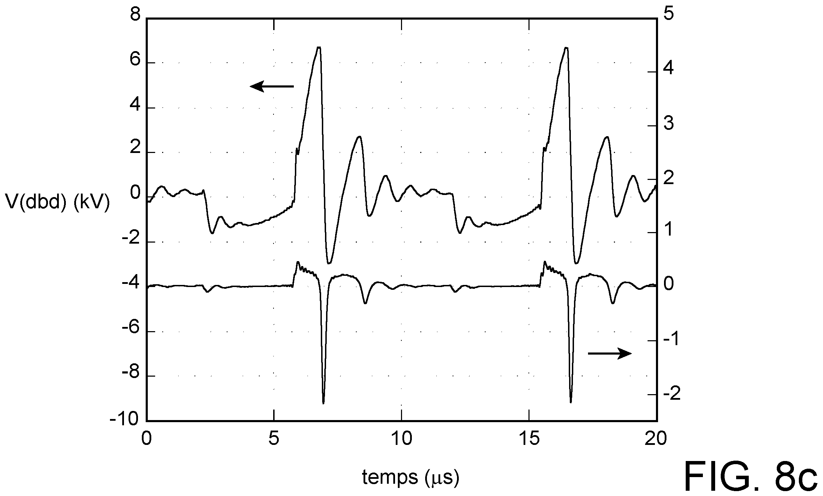

- la figure 8c est une représentation graphique, d'une mise en œuvre expérimentale du générateur à impulsions électriques selon l'invention, dans le contexte d'une stratégie de commande en courant limité, le graphique représentant le courant I(dbd) (axe vertical droite) traversant le dispositif à décharge à barrière diélectrique, ainsi que la tension V(dbd) (axe vertical gauche) aux bornes dudit dispositif, en fonction du temps (axe horizontal),

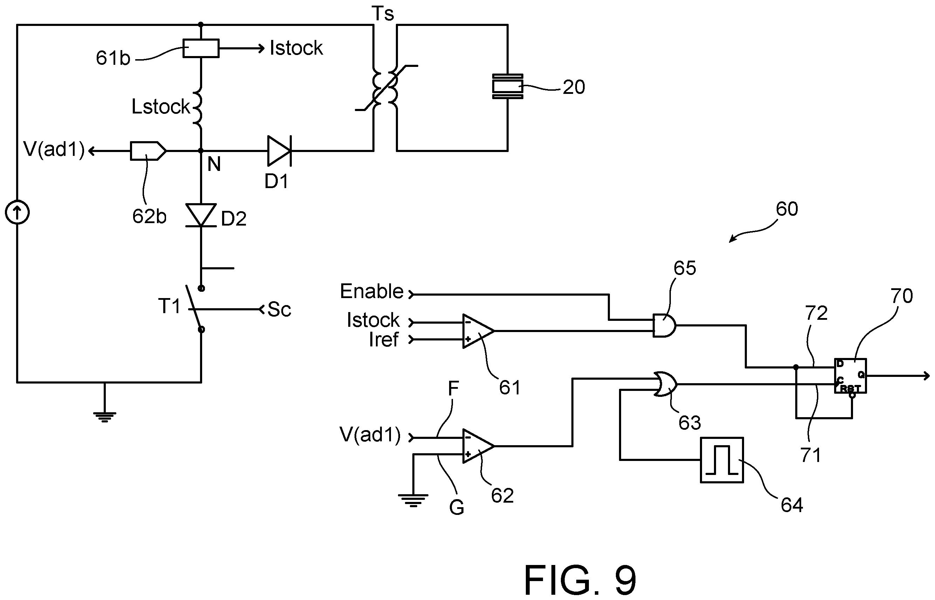

- la figure 9 est une représentation schématique de la topologie d'un module de commande destiné à commander l'interrupteur commandé T1 selon une stratégie de commande en puissance optimale,

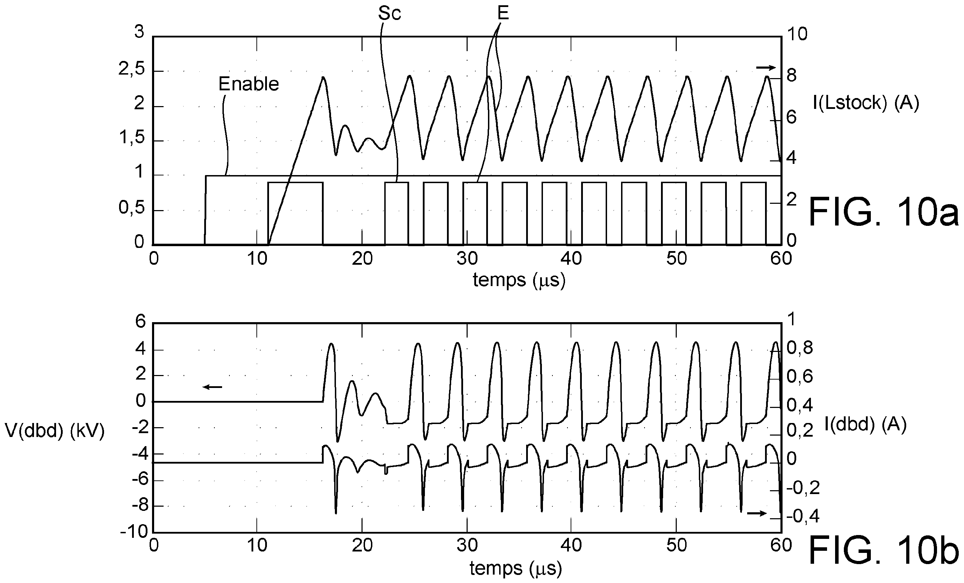

- la figure 10a est une représentation graphique, d'une simulation numérique du fonctionnement du générateur à impulsions électriques selon l'invention, dans le contexte du stratégie de commande puissance optimale, le graphique représentant le courant Istock traversant l'inductance Lstock (axe vertical droite), et le signal de commande Sc généré par la bascule D (axe vertical gauche) et envoyé à l'interrupteur commandé T1, en fonction du temps (axe horizontal),

- la figure 10b est une représentation graphique d'une simulation numérique du fonctionnement du générateur à impulsions électriques selon l'invention, dans le contexte d'une stratégie de commande en puissance optimale, le graphique représentant le courant I(dbd) (axe vertical droite) traversant le dispositif à décharge à barrière diélectrique, ainsi que la tension V(dbd) (axe vertical gauche) aux bornes dudit dispositif, en fonction du temps (axe horizontal),

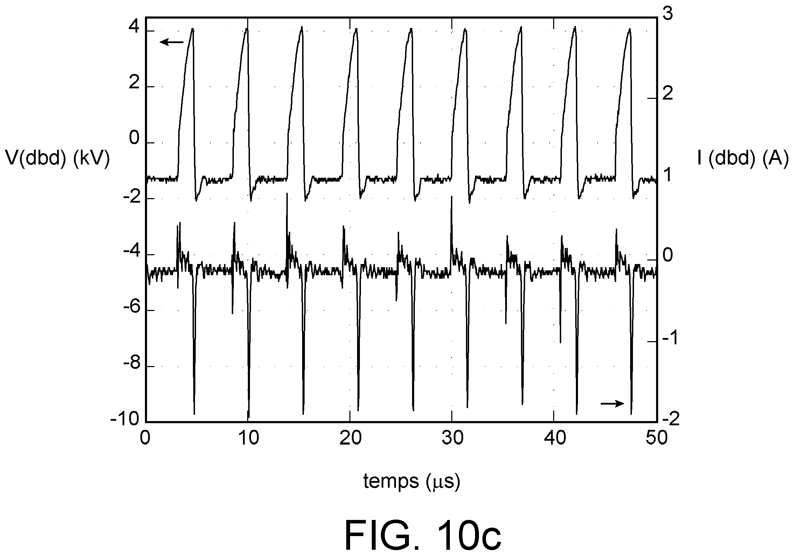

- la figure 10c est une représentation graphique, d'une mise en œuvre expérimentale du générateur à impulsions électriques selon l'invention, dans le contexte d'une stratégie de commande en puissance optimale, le graphique représentant le courant I(dbd) (axe vertical droite) traversant le dispositif à décharge à barrière diélectrique, ainsi que la tension V(dbd) (axe vertical gauche) aux bornes dudit dispositif, en fonction du temps (axe horizontal),

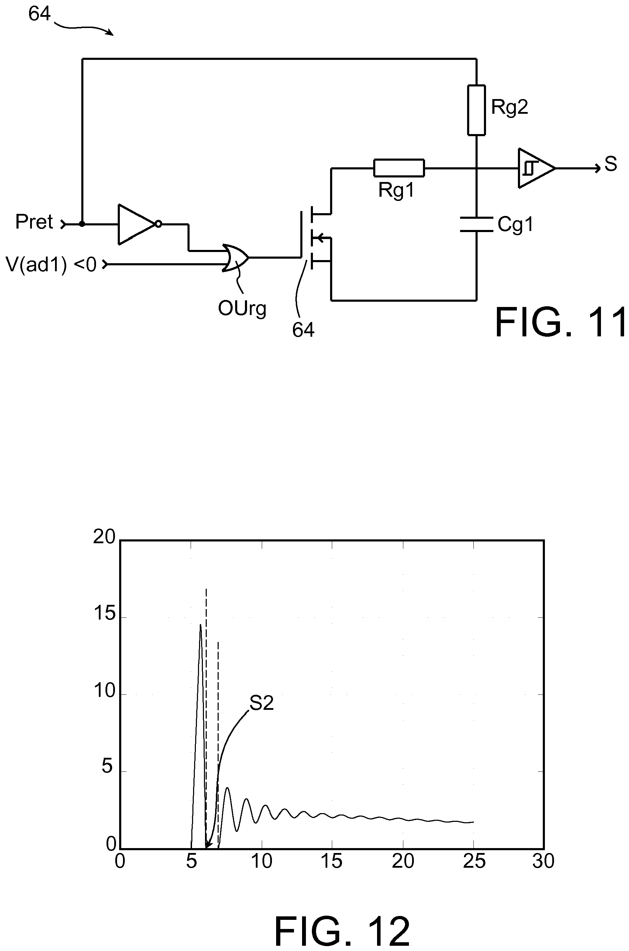

- la figure 11 représente un exemple de générateur de signal d'amorçage,

- la figure 12 représente l'évolution du courant Istock (sur l'axe vertical) en fonction du temps (sur l'axe horizontal) dans le cadre d'un transfert total d'énergie de l'inductance Lstock vers le dispositif à décharge à barrière diélectrique selon un mode de réalisation de l'invention.

## EXPOSÉ DÉTAILLÉ DE MODES DE RÉALISATION PARTICULIERS

L'invention décrite de manière détaillée ci-dessous met en œuvre un générateur d'impulsions électriques destiné à alimenter un dispositif à décharge à barrière diélectrique. Comme nous le verrons dans la suite de la description, le générateur selon l'invention comprend une inductance Lstock destinée à stocker de l'énergie, pendant une phase de charge, fournie par une source de tension continue, et restituer l'énergie sous forme d'une impulsion à un dispositif à décharge à barrière diélectrique par l'intermédiaire d'un transformateur élévateur. Nous verrons également, sous certaines conditions, qu'un tel générateur à impulsions électriques permet de récupérer de l'énergie non consommée par le dispositif à décharge à barrière diélectrique sans impliquer la commutation de commutateurs de puissance.

A la figure 2, on peut voir une représentation schématique du générateur d'impulsions électrique 10 selon l'invention.

Le générateur d'impulsions électriques 10 comprend deux bornes d'alimentation A et B destinées à être connectées à une source de tension continue 30.

La source de tension continue 30 peut couvrir une large gamme de tension, par exemple des tensions comprises entre 10 V et 350 V.

Plus particulièrement, la source de tension continue 30 peut être une source très basse tension comprise entre 10 V et 50 V.

Le générateur d'impulsions électriques 10 comprend une inductance Lstock. Par inductance, nous entendons une bobine constituée d'un enroulement de fil conducteur éventuellement autour d'un noyau en matériau ferromagnétique.

Le générateur d'impulsions électriques 10 comprend un transformateur élévateur Ts doté d'un circuit primaire Ts1 et un circuit secondaire Ts2. Un transformateur élévateur comprend en général un noyau magnétique autour duquel sont enroulés les circuits primaire Ts1 et secondaire Ts2.

L'inductance Lstock est agencée de manière à stocker une énergie fournie, pendant une phase de charge, par la source de tension continue 30, et à transférer ladite énergie, pendant une phase de décharge, à un dispositif à décharge à barrière diélectrique 20 par l'intermédiaire du transformateur élévateur Ts. Ainsi, le générateur d'impulsions électriques 10 comprend également un moyen de commutation dont la commutation assure l'alternance entre phase de charge et phase de décharge. Ainsi, pendant la phase de charge, le moyen de commutation est fermé de sorte que la tension délivrée par la source de tension continue 30 est imposée aux bornes de l'inductance Lstock. Pendant la phase de décharge, le moyen de commutation est ouvert de sorte que l'inductance Lstock est isolée de la source de tension continue 30. Ainsi, pendant la phase de décharge, l'inductance Lstock transfert l'énergie stockée en générant un courant I(d1) dans le circuit primaire Ts1 (autrement dit une boucle de courant se forme entre l'inductance Lstock et le circuit primaire Ts1).

Le moyen de commutation peut comprendre un interrupteur commandé T1, plus particulièrement l'interrupteur commandé T1 peut être un commutateur de puissance, par exemple un transistor à effet de champ à grille isolée (acronyme anglais de « Metal Oxide Semiconductor Field Effect Transistor » ou « MOSFET » selon la terminologie Anglo-Saxonne).

Le générateur à impulsion électrique 10 est également pourvu d'une diode D1.

Par ailleurs, les bornes du circuit secondaire Ts2 sont destinées à imposer une tension et/ou un courant aux bornes du dispositif à décharge à barrière diélectrique 20.

Nous allons maintenant décrire un agencement particulier du générateur d'impulsions électriques 10 donnée à titre d'exemple non limitatif.

Le générateur d'impulsion électrique 10 comprend un premier circuit 40 et un second circuit 50 électriquement connectés en série au niveau d'un nœud N.

Le premier circuit 40 comprend deux branches 41 et 42 reliant chacune le nœud N et la borne A du générateur à impulsions électrique 10. Il est ainsi entendu que les deux branches 41 et 42 sont connectées en parallèle.

Le premier circuit 40 est avantageusement dépourvu de moyen de commutation.

La branche 41 comprend l'inductance Lstock.

La branche 42 comprend la diode D1 connectée en série, par sa cathode, au circuit primaire Ts1 du transformateur élévateur Ts. L'anode de la diode D1 est connectée au nœud N.

Le second circuit 50, reliant le nœud N et la borne B, comprend l'interrupteur commandé T1.

De manière avantageuse, le second circuit 50 peut également comprendre une diode D2 interposée entre l'interrupteur commandé T1 et le nœud N, et destinée à imposer un sens de passage du courant dans l'interrupteur commandé T1 lorsque ce dernier est en position fermée. Nous verrons par la suite que la diode D2 peut être particulièrement avantageuse lorsque le générateur à impulsions électriques 10 est commandé selon une stratégie dite « stratégie en puissance optimale ».

Comme nous le verrons dans la suite de la description, seul le premier circuit 40 est sollicité lors de la phase de décharge. Cette phase de décharge, comme nous avons pu le décrire dans la section « Art Antérieur », donne lieu à de fortes variations de tension et de courant que seuls les éléments constitutifs du premier circuit 40 se verront imposées. Plus particulièrement, les pointes de courant survenant lors de l'apparition de la décharge, peuvent n'être supportées que par le circuit secondaire Ts2 du transformateur élévateur Ts dès lors que le noyau magnétique est saturable. En effet, le noyau magnétique du transformateur Ts peut être dimensionné pour se saturer lors de la phase de décharge. On observe ainsi une chute de la valeur de l'inductance L2 du circuit secondaire Ts2. Il en résulte une rupture, au moins partielle, du couplage par induction entre le circuit primaire Ts1 et le circuit secondaire Ts2. Ainsi, pendant la phase de décharge, et de manière particulièrement avantageuse, aucun courant ne traverse l'interrupteur commandé T1 dès lors que le noyau magnétique est saturé. Ceci est un avantage considérable au regard du dispositif décrit dans le document [2].

Par noyau magnétique saturé, nous entendons un noyau magnétique présentant un champ magnétique de saturation selon la direction d'enroulement du circuit secondaire Ts2.

Le champ magnétique de saturation est défini comme le champ magnétique maximal pouvant être créé dans le noyau magnétique.

Le dispositif à décharge à barrière diélectrique est susceptible de générer une décharge à barrière diélectrique dès qu'une tension V, supérieure à une tension $V_D$, est imposée à ses bornes. La tension $V_D$ est fonction de la nature du matériau diélectrique, de sa forme, de son positionnement dans le dispositif 20, et également de la tension de claquage du gaz compris dans le dispositif à décharge à barrière diélectrique. La tension $V_D$ est un paramètre caractéristique du dispositif à décharge à barrière diélectrique 20, et est connu de l'homme du métier qui pourra se référer au document [1] cité à la fin de la description. La tension $V_D$ est donc une tension de fonctionnement du dispositif à décharge à barrière diélectrique 20.

La tension de fonctionnement $V_D$ est ainsi définie comme la tension au-dessus de laquelle le dispositif à décharge à barrière diélectrique 20 est susceptible de générer une décharge à barrière diélectrique.

Pendant le déroulement de la décharge à barrière diélectrique, l'état magnétique du noyau magnétique (i.e. : le champ magnétique au sein du noyau) est modifié. Plus particulièrement, l'état magnétique du noyau est modifié par la variation de flux magnétique imposée par la tension aux bornes du dispositif à décharge à barrière diélectrique provoquée par la génération de la décharge à barrière diélectrique.

Ainsi, la variation de flux magnétique est dominée par la tension de fonctionnement $V_D$ du dispositif à décharge à barrière diélectrique 20. Par conséquent, la connaissance de la tension de fonctionnement $V_D$ permet de dimensionner le noyau magnétique du transformateur élévateur de manière à ce que ledit noyau magnétique soit magnétiquement saturé au moment où la décharge à barrière diélectrique est générée.

Le dimensionnement du noyau magnétique pour le rendre saturable dans les conditions d'utilisations précitées peut comprendre le choix d'un matériau magnétique spécifique (par exemple un matériau de type Ferrite) et/ou la forme dudit noyau, et/ou la taille dudit noyau.

Le dimensionnement du noyau magnétique pour le rendre saturable dans les conditions d'utilisation imposées par le dispositif à décharge à barrière diélectrique 20 peut comprendre un ajustement de la section magnétique dudit noyau magnétique.

A cet égard, l'homme du métier trouvera tout l'enseignement nécessaire au dimensionnement des noyaux magnétiques dans le document [3] cité à la fin de la description.

Par ailleurs, la Demanderesse a remarqué qu'un noyau magnétique de section magnétique A, inférieure à une section magnétique Amin définie par l'équation (1), conviendrait à la mise en œuvre de l'invention (à savoir obtenir un noyau magnétique saturable dans les conditions d'utilisation précitées).

$$A_{min} = \frac{C_{eq1}V_D^2}{2N_1 I_{max}B_{sat}} \qquad (1)$$

où $C_{eq1}$ est la capacité équivalente du matériau diélectrique du dispositif à décharge à barrière diélectrique, Ni le nombre de spires du circuit primaire du transformateur élévateur Ts, $I_{max}$ le courant circulant dans l'inductance Lstock à l'issue de la première séquence ($I_{max}$ est défini dans la suite de la description), et $B_{sat}$ la valeur du champ magnétique de saturation dans le noyau.

En général, la saturation du noyau magnétique d'un transformateur élévateur est un effet indésirable, car le couplage entre les circuits primaire et secondaire est rompu.

Dans le cadre de la présente invention, la rupture du couplage permet de réinjecter une partie de l'énergie non consommée par le dispositif à décharge à barrière diélectrique dans ledit dispositif à décharge à barrière diélectrique.

Ainsi, la tension aux bornes du dispositif à décharge à barrière diélectrique engendre une augmentation du flux magnétique dans le noyau du transformateur Ts qui est dimensionné pour saturer à partir d'une valeur définie de la tension aux bornes de la décharge à barrière diélectrique.

Par ailleurs, le fait de rendre saturable le noyau magnétique dans les conditions de fonctionnement du dispositif à décharge à barrière diélectrique permet de réduire de la taille dudit noyau magnétique.

En relation avec les figures 3a à 3d, 4a et 4b, nous allons maintenant décrire les quatre (4) séquences de fonctionnement du générateur à impulsions électrique 10 sur une impulsion électrique unique. Nous considérons dans la suite de la description que le générateur à impulsion électrique comprend la diode D2, et que le noyau magnétique du transformateur élévateur Ts est dimensionné pour se saturer magnétiquement dès lors que la décharge à barrière diélectrique est générée. Autrement dit, le noyau magnétique du transformateur élévateur est dimensionné relativement à la tension de fonctionnement $V_D$ du dispositif à décharge à barrière diélectrique.

La première séquence (figure 3a) correspond à la phase de charge de l'inductance Lstock. Pendant cette première séquence, l'interrupteur commandé T1 est fermé pendant un temps t1. L'inductance Lstock se voit alors imposer la tension Vs de la source de tension continue 30. Une boucle de courant, dont l'intensité Istock croit linéairement circule ainsi dans l'ensemble constitué par la source de tension continue 30, l'inductance Lstock, la diode D2 et l'interrupteur commandé T1 (figure 4a).

Au bout du temps t1, le courant Istock atteint la valeur Imax. La valeur $I_{max}$ peut facilement être ajustée, en modulant le temps t1, en fonction des besoins en terme de forme d'onde de la tension et de courant devant être générés par le générateur à impulsions électriques 10. Par conséquent, la topologie peut fonctionner dans une large gamme de valeurs de tension Vs, puisqu'il suffit d'adapter le temps de charge t1 en fonction de la valeur $I_{max}$ souhaitée.

Au bout du temps t1, la seconde séquence (figure 3b) débute par l'ouverture de l'interrupteur commandé T1. La seconde séquence dure un temps t2. Pendant cette seconde séquence, l'énergie stockée dans l'inductance Lstock est transférée de façon résonante dans le dispositif à décharge à barrière diélectrique 20 à travers le transformateur élévateur Ts. Le dispositif à décharge à barrière diélectrique se comporte comme une capacité dont le volume de décharge est occupé par un gaz. On observe ainsi, pendant le transfert de l'énergie stockée, que la tension V(dbd) à ses bornes croît selon une portion de sinusoïde (figure 4b).

De manière avantageuse, le taux de croissance de cette tension V(dbd) peut être contrôlé par l'ajustement du courant Imax, et donc par la durée de fermeture de l'interrupteur commandé T1 (autrement dit le temps t1).

Lorsque la tension imposé au gaz contenu dans le dispositif à décharge à barrière diélectrique 20 atteint la tension de claquage Vc (dit également tension d'amorçage) dudit gaz, ce dernier s'ionise pour créer une décharge transitoire. La tension aux bornes du dispositif à décharge à barrière diélectrique engendre une augmentation du flux magnétique dans le noyau du transformateur Ts qui est dimensionné pour se saturer magnétiquement à partir d'une valeur définie $V_D$ de la tension aux bornes de la décharge à barrière diélectrique, la tension définie $V_D$ étant supérieure à la tension de claquage Vc du gaz.

A l'issue de la seconde séquence, une saturation du noyau magnétique du transformateur élévateur Ts intervient, soit avant le transfert total de l'énergie de l'inductance Lstock vers le dispositif à décharge à barrière diélectrique soit après.

La figure 12 illustre l'évolution du courant Istock (sur l'axe vertical) en fonction du temps (sur l'axe horizontal) dans le cadre d'un transfert total d'énergie de l'inductance Lstock vers le dispositif à décharge à barrière diélectrique 20. On observe très clairement une annulation du courant Istock à l'issue de la seconde séquence (point S2 sur la figure 12)

La troisième séquence débute donc par la saturation du noyau magnétique du transformateur élévateur Ts. Tel que décrit précédemment, lorsque le noyau magnétique du transformateur élévateur Ts sature, la valeur de l'inductance L2 du circuit secondaire Ts2 chute (le transformateur se transforme en inductance de fuite). Il en résulte une rupture, au moins partielle, du couplage par induction entre le circuit primaire Ts1 et le circuit secondaire Ts2, de sorte que le courant circulant dans la boucle formée par l'inductance Lstock, la diode D1 et le circuit primaire Ts1 tourne en roue libre.

En parallèle, le dispositif à décharge à barrière diélectrique 20 a consommé au moins en partie l'énergie stockée qui lui a été transférée lors de la seconde séquence. Une énergie résiduelle, non consommée, reste stockée sous la forme de charges à la surface du ou des diélectriques du circuit à décharge à barrière diélectrique 20. Le dispositif à décharge à barrière diélectrique 20 en parallèle avec la faible inductance formée par le circuit secondaire Ts2 (du fait de la saturation du noyau magnétique) forment donc un dipôle de fréquence propre faible. L'énergie résiduelle est alors transférée de manière résonnante entre le dispositif à décharge à barrière diélectrique 20 vers l'inductance de fuite du transformateur élévateur saturable Ts pendant le temps t3. Il est ainsi observé une chute brutale et brève de la tension V(dbd) aux bornes du dispositif à décharge à barrière diélectrique 20 (figure 3c, et figure 4b).

Dès lors que le transfert de l'énergie résiduelle vers l'inductance de fuite est effectué, ladite énergie résiduelle est réinjectée dans le circuit à décharge à barrière diélectrique 20, également par résonnance, et produit une seconde impulsion de tension aux bornes du dispositif à décharge à barrière diélectrique 20 de polarité opposée à la première impulsion issue de la seconde séquence. Une chute brutale de la tension s'accompagne d'une deuxième décharge, coïncidant avec une pointe de courant de sens opposé à la première.

La saturation du noyau magnétique observée pendant la troisième séquence donne lieu à un phénomène brutal de décroissance de la tension V(dbd) aux bornes du dispositif à décharge à barrière diélectrique 20, et également une impulsion de courant (une pointe de courant) dans ledit dispositif 20 d'une grande amplitude. Aussi, contrairement au dispositif décrit dans le document [2], la pointe de courant circule exclusivement entre le circuit secondaire Ts2 et le dispositif à décharge diélectrique 20. Ces éléments peuvent supporter sans défaillance cette surintensité transitoire. En particulier, la pointe de courant ne traverse pas l'interrupteur commandé T1 et ne nécessite donc pas le surdimensionnement de ces composants, contrairement aux cas évoqués dans l'état de l'art.

L'amplitude de la seconde impulsion de tension est généralement inférieure (en valeur absolue) à celle de la première. Cette décroissance est au moins en partie due aux éléments dissipatifs du circuit. Ainsi, une faible amplitude de la seconde impulsion de tension indique un bon transfert de l'énergie injectée par l'inductance dans la décharge.

Pendant la troisième séquence, le sens du courant, circulant dans l'ensemble circuit secondaire Ts2 et dispositif à décharge à barrière diélectrique 20, maintient la saturation du noyau magnétique du transformateur élévateur Ts.

Lors de la quatrième séquence, qui s'étend sur un temps t4, l'énergie est à nouveau entièrement stockée dans le dispositif à décharge à barrière diélectrique 20, donc au maximum (en valeur absolue) de la seconde impulsion de tension. L'énergie du dispositif à décharge à barrière diélectrique 20 est renvoyée, par résonnance, au circuit secondaire Ts2. Cependant, le sens du courant, inversé par rapport à la troisième séquence (figure 3d), désature le noyau magnétique, rétablissant ainsi le couplage entre les circuits primaire Ts1 et secondaire Ts2.

Le transfert résonant ne se fait plus entre le dispositif à décharge à barrière diélectrique 20 et le circuit secondaire Ts2, mais entre ledit dispositif 20 et le circuit primaire Ts1 en parallèle avec l'inductance Lstock (à travers D1). L'énergie résiduelle dans le dispositif à décharge à barrière diélectrique 20 est donc récupérée et répartie entre le transformateur élévateur saturable Ts et l'inductance Lstock.

Si l'interrupteur commandé T1 n'est pas remis en conduction par la suite, la résonance se poursuit entre le dispositif à décharge à barrière diélectrique 20, le transformateur élévateur saturable Ts et l'inductance Lstock. On observe alors une oscillation de la tension V(dbd) aux bornes du dispositif à décharge à barrière diélectrique 20. En général, l'amplitude des oscillations en tension V(dbd) aux bornes du dispositif à décharge à barrière diélectrique n'est pas suffisante pour amorcer de nouvelles décharges dans le gaz, et les oscillations finissent par s'amortir à cause des éléments parasites dissipatifs (en particulier les résistances des circuits primaire Ts1 et secondaire Ts2, et de l'inductance Lstock).

Différents cas de figure peuvent alors être considérés pour la fermeture de l'interrupteur commande T1.

Selon un premier cas, l'interrupteur commandé T1 peut être fermé au bout d'un temps supérieur au temps de relaxation des oscillations de la tension V(dbd). Dans ce cas, le système est dans son état initial et cette séquence est donc identique à la séquence 1.

Selon un second cas, l'interrupteur commandé T1 peut être fermé avant la relaxation des oscillations de la tension V(dbd).

Dans ce cas, le courant circulant dans l'inductance Lstock et le circuit primaire Ts1 n'est pas nul (la diode D1 étant passante). L'anode et la cathode de la diode D1 sont à un potentiel, respectivement, V(ad1) et V(kd1), oscillant et centré sur Vs.

A la fermeture de l'interrupteur commandé T1, le potentiel V(kd1) est donc soit positif soit négatif.

Si V(kd1) est négatif au moment de la fermeture de l'interrupteur commande T1, la diode D2 est bloquée. Par conséquent, la fermeture de l'interrupteur commandé T1 se fait à courant nul, ce qui évite les pertes par commutation dudit interrupteur commandé T1. Dès la fermeture de l'interrupteur commandé T1, le potentiel V(kd1) (représenté à la figure 5b) met un temps t5 pour repasser par zéro, conférant ainsi à la diode D2 un état passant. La tension aux bornes du circuit primaire est également maintenue à la valeur Vs imposée par la source de tension continue 30, ce qui conduit à une démagnétisation du noyau magnétique du transformateur élévateur Ts au bout d'un temps tdem (figures 5a et 5b).

A l'inverse, si V(kd1) est positif (figure 6b) au moment de la fermeture de l'interrupteur commande T1, la diode D2 est passante et la fermeture de T1 impose un potentiel à l'anode de la diode D1 proche de zéro, ce qui conduit au blocage de cette dernière, et à une interruption brutale du courant passant dans le circuit primaire Ts1. Il s'en suit donc un transfert d'une l'énergie résiduelle du transformateur Ts vers le dispositif à décharge à barrière diélectrique 20. Le dispositif à décharge à barrière diélectrique 20 impose alors, à travers le transformateur élévateur Ts, une chute du potentiel de la cathode de la diode D1 pendant un temps t5, jusqu'à atteindre la valeur zéro, valeur à laquelle la diode D1 redevient passante et impose la polarisation du circuit primaire Ts1 à une tension Vs. Il s'en suit la phase de démagnétisation d'un temps tdem (figures 6a et6b), comme indiqué dans le point précédent.

Suite à la démagnétisation du noyau magnétique du transformateur élévateur Ts, le courant I(d1) (figures 5b et 6b) s'annule dans le circuit primaire, et le système constitué de la diode D1, du transformateur élévateur Ts et du dispositif à décharge à barrière diélectrique 20 reste ainsi dans un état stationnaire. Des oscillations amorties de la tension V(dbd) entre le dispositif à décharge à barrière diélectrique 20, et l'inductance du circuit secondaire Ts2 peuvent cependant subsister.

Nous allons maintenant décrire différentes stratégies de commande de l'interrupteur commandé T1 pour la production et l'entretien d'une décharge à barrière diélectrique dans le dispositif 20.

Tel que mentionné précédemment, certains modes de commutation semblent plus favorables que d'autres pour produire et entretenir une décharge à barrière diélectrique. Aussi, il peut sembler préférable, pour entretenir la décharge, de commander la fermeture de l'interrupteur commandé T1 lorsque la tension Vkd1 est négative, ou lorsque la tension au nœud N est négative, ce qui est équivalent du point de vue de la stratégie de commande.

Nous allons maintenant décrire trois stratégies de commande de l'interrupteur commandé T1.

Le générateur d'impulsions électrique 10 peut être doté d'un module de commande 60 de l'interrupteur commandé T1. Plus particulièrement, le module de commande 60 peut être adapté pour générer un signal de commande Sc destiné à commander l'ouverture et la fermeture de l'interrupteur commandé T1.

Une première stratégie dite « Stratégie de commande PWM » peut être appliquée.

La première stratégie comprend la commande de l'interrupteur commandé par un signal de commande logique de modulation de largeur d'impulsion, MLI (« Pulse Width Modulation » ou « PWM » selon la terminologie Anglo-Saxonne). Cette première stratégie peut être mise en œuvre par le module de contrôle 60. Plus particulièrement, le module de contrôle 60 peut comprendre un contrôleur logique PWM dont la mise en œuvre est connue de l'homme du métier. Le signal de commande logique PWM est représenté par des fonctions créneau sur les figures 5b et 6b. Cependant, dès lors le courant parcourant l'inductance Lstock (I(Lstock)) croit linéairement pendant la fermeture de l'interrupteur commandé T1, une succession de créneaux de commande de largeur fixe va donner lieu théoriquement à un courant de plus en plus important à chaque créneau (tel qu'illustré aux les figures 5b et 6b sur 2 créneaux).

En réalité, plus le courant Imax est important, plus la décharge à barrière diélectrique absorbe de l'énergie, ce qui peut finalement conduire à un équilibre et un fonctionnement permanent.

Une implémentation de la topologie indiquée en figure 2, dotée d'un filtre d'entrée en parallèle avec la source de tension continue 20 (Vs) constitué par une capacité de 20 μF, avec un mode de commande PWM a donné un fonctionnement permanent stable sur un dispositif à décharge à barrière diélectrique 20 comprenant une lampe à excimères (décrite dans le document [4] cité à la fin de la description). Les paramètres du convertisseur 10 sont donnés au tableau 1.

**Tableau 1**

| Paramètre | Valeur | Unité |
|---|---|---|
| Source de tension continue 20 | Tension comprise entre 10 V et 100 V | V |
| Inductance Lstock | Inductance comprise entre 15 et 50 | μH |
| Diodes D1 et D2 | Diode Schottky | |
| Interrupteur commandé T1 | Mosfet N | |
| Transformateur Ts | Pouvant comprendre un noyau de ferrite, et délivrer une tension comprise entre 1000 V et 8000 V aux bornes de sortie de son circuit secondaire. | |
| Contrôle logique PWM | 100 kHz, 10% de rapport cyclique | |

Le dimensionnement des diodes D1, et D2, ainsi que du transformateur Ts est à la portée de l'homme du métier, et n'est donc pas décrit en détails dans la présente demande.

L'avantage de la première stratégie dit « stratégie de commande PWM » est d'être simple à mettre en œuvre sur la topologie de générateur à impulsions électriques 10 selon l'invention. Par ailleurs, la stratégie de commande PWM comprend deux degrés de liberté de contrôle, à savoir :

- le rapport cyclique qui impacte la valeur Imax,
- la fréquence, qui impacte la puissance moyenne injectée dans le dispositif à décharge à barrière diélectrique.

Une seconde stratégie dite « Stratégie de commande en courant limité » peut être également appliquée.

L'objet de la stratégie en courant limité comprend la commande de la fermeture de l'interrupteur commandé T1 à une fréquence définie, par exemple à la fréquence d'une horloge H1, et l'ouverture dudit interrupteur commandé T1 dès que le courant traversant l'inductance Lstock dépasse une valeur de courant de référence Iref (par exemple la valeur Imax précédemment citée). Cette méthode permet de garantir un fonctionnement stable.

Ainsi, afin de mettre en œuvre la stratégie de commande en courant limité, il peut être intéressant de doter le module de commande 60 (représenté à la figure 7) d'un moyen de comparaison 61 du courant Istock traversant l'inductance Lstock avec le courant de référence Iref. Ainsi, dès lors que le courant Istock est supérieur au courant Iref, le module de commande 60 est adapté pour générer un signal de commande Sc d'ouverture de l'interrupteur commandé T1. Le moyen de comparaison 61 peut recevoir la mesure du courant Istock d'une sonde de courant 61b.

De manière avantageuse, les moyens de comparaison 61 comprennent un premier comparateur.

Par premier comparateur, nous entendons un comparateur adapté pour faire la différence entre deux grandeurs d'entrée analogiques, et générer un signal de sortie logique dit « haut » ou « bas » en fonction du signe de ladite différence. Les comparateurs sont connus de l'homme du métier, et ne seront donc pas décrits en détails dans la description. Dans le cadre de la présente invention, le signal en sortie du premier comparateur sera dit « haut » si le courant Istock est inférieur au courant de référence Iref, et il sera bas dans le cas contraire.

Toujours de manière avantageuse, le module de commande 60 comprend une bascule de type D (ci-après nommée bascule D 70) commandant l'interrupteur commandé T1, et comprenant une sortie Sc destinée à envoyer le signal de commande Sc à l'interrupteur commandé T1.

Par définition, une bascule D 70 est un circuit logique comprenant une entrée de contrôle, notée C, une entrée de données, notée D, et une sortie notée Q. En fonctionnement, le signal d'entrée D est copié sur la sortie Q sur chaque front montant de l'entrée C. Une bascule D peut être dotée d'une entrée SET et/ou RESET (notée RST) qui imposent respectivement un état « haut » et « bas » de la sortie Q, quel que soit l'état des entrées D 72 et C 71. L'entrée contrôlée (entrée C 71) et l'entrée de données (entrée D 72) conserveront ces définitions tout au long de la description.

Dans la cadre de la présente invention, nous entendons par état haut au niveau de la sortie Sc de la bascule D 70, un état destiné à commander la fermeture de l'interrupteur commandé T1. De manière analogue, nous entendons par état bas au niveau de la sortie Sc de la bascule D 70, un état destiné à commander l'ouverture de l'interrupteur commandé T1.

Dans le contexte de la présente invention, le signal imposé à l'entrée D 72 et RST# (RESET, logique inversée) de la bascule D 70 est considéré comme haut si le courant Istock est inférieur au courant de référence Iref, et le signal sera bas dans le cas contraire.

De manière avantageuse, un signal de commande externe, par exemple un signal d'horloge H1 en créneau, est envoyé sur l'entrée C 71 de la bascule D 70.

Un front montant du signal d'horloge H1 en créneau correspond, dans le cadre de la présente invention, à un état haut imposé à l'entrée C 71 de la bascule D 70. Ainsi, dès lors que l'entrée C 71 se voit imposer un état haut, un signal de commande Sc de fermeture est envoyé par la bascule D 70 à l'interrupteur commandé T1, à condition que le signal imposé à l'entrée RST# (identique à celui imposé sur l'entrée D 72) soit « haut »..

Les figures 8a et 8b représentent les oscillogrammes obtenus par simulation numérique du générateur à impulsions électriques 10 commandé par le module de commande (60), tandis que la figure 8c représente les oscillogrammes obtenus par une mise en œuvre expérimentale du générateur à impulsions électriques 10 commandé par le module de commande 60. Plus particulièrement, la figure 8a représentent le courant Istock traversant l'inductance Lstock, le signal d'horloge H1 et le signal de commande Sc généré par la bascule D 70 et envoyé à l'interrupteur commandé T1. Les figures 8b et 8c représentent le courant I(dbd) traversant le dispositif à décharge à barrière diélectrique 20, ainsi que la tension V(dbd) aux bornes dudit dispositif, respectivement dans le cadre d'une simulation numérique et d'une mise en œuvre expérimentale de l'invention.

Nous notons que les oscillogrammes obtenus par simulation numérique et expérimentalement sont très similaires.

Nous notons qu'à chaque créneau du signal de commande Sc correspond une impulsion du courant Istock (par exemple, l'impulsion indiquée par le repère E sur la figure 8a). L'impulsion de courant Istock est suivie d'une décharge dans le dispositif à décharge à barrière diélectrique 20 repérable sur la figure 8b par une forte variation d'amplitude de la tension V(dbd) et du courant I(dbd) mesuré aux bornes dudit dispositif 20.

Une implémentation de la topologie indiquée en figure 7, dotée d'un filtre d'entrée en parallèle avec la source de tension continue 30 (de tension Vs). Le filtre d'entrée comprend une capacité de 20 μF, une diode de suppression de surtensions en parallèle avec l'inductance Lstock.

Les paramètres du convertisseur 10 sont donnés au tableau 2.

**Tableau 2**

| Paramètre | Valeur | Unité |
|---|---|---|
| Source de tension continue 20 | Tension comprise entre 10 V et 100 V | V |
| Inductance Lstock | Inductance comprise entre 15 et 50 | µH |
| Diodes D1, D2 | Diode Schottky | |
| Interrupteur commandé T1 | Mosfet N | |
| Transformateur Ts | Pouvant comprendre un noyau de ferrite, et délivrer une tension comprise entre 1000 V et 8000 V aux bornes de sortie de son circuit secondaire. | |
| Signal d'horloge H1 | 100 kHz | |

La stratégie en courant limité permet un fonctionnement permanent stable et s'adapte parfaitement à une utilisation à puissance modérée. Elle permet une grande gamme de gradation puisqu'en maintenant une consigne de courant nominale et en baissant la fréquence du signal d'horloge H1, on peut réduire significativement la puissance injectée dans le dispositif à décharge à barrière diélectrique 20 sans provoquer son extinction.

Une troisième stratégie dite « stratégie en puissance optimale », permettant de garantir la fermeture de l'interrupteur commandé T1 pour une tension V(kd1) négative, va maintenant être décrite.

Ainsi, afin de mettre en œuvre la stratégie en puissance optimale, le module de commande 60 (représenté à la figure 9) reprend le moyen de comparaison 61 du module de commande 60 permettant de mettre en œuvre la stratégie de commande en courant limité.

De manière avantageuse, le moyen de comparaison 61 comprend un premier comparateur.

Toujours de manière avantageuse, le module de commande 60 comprend une bascule D 70 commandant l'interrupteur commandé T1, et comprenant une sortie Sc destinée à envoyer le signal de commande Sc à l'interrupteur commandé T1 (figure 9).

Une bascule D 70 est un circuit logique comprenant une entrée de contrôle, notée C, une entrée de données, notée D, et une sortie noté Q. En fonctionnement, le signal d'entrée D (au niveau de l'entrée D 72) est copié sur la sortie Q sur chaque front montant du signal imposé à l'entrée C 71. Une bascule D peut être dotée d'une entrée SET et/ou RESET qui imposent respectivement un état « haut » et « bas » de la sortie Q, quel que soit l'état des entrées D 72 et C 71.

Dans le contexte de la présente invention, le signal imposé à l'entrée D 72 de la bascule D 70 est considéré comme haut si le courant Istock est inférieur au courant de référence Iref, et le signal sera bas dans le cas contraire.

Le module de commande 60 peut, en outre, comprendre un moyen de détermination du signe de la tension 62 au nœud N (noté V(adl)), le module de commande 60 étant adapté pour générer un signal de commande Sc commandant la fermeture de l'interrupteur commandé T1 dès lors que la tension V(ad1) au nœud N est négative.

Le moyen de détermination du signe de la tension 62 peut recevoir la mesure de la tension V(ad1) d'une sonde de tension 62b.

Le moyen de détermination du signe de la tension 62 est, par exemple, un second comparateur.

Plus particulièrement, le second moyen de comparaison est adapté pour mesurer la différence entre la valeur de la tension V(ad1) et le potentiel de la masse. Ainsi, en fonctionnement, la mesure de la tension V(ad1) est injectée au niveau d'une première entrée F du second comparateur, tandis qu'une seconde entrée G du second comparateur est connectée à la masse.

De manière avantageuse, le moyen de détermination du signe de la tension 62 est connecté à l'entrée C 71 de la bascule D 70, le moyen de détermination du signe de la tension 62 étant adapté pour envoyer un état haut à l'entrée C 71 de la bascule D 70 dès lors que la tension V(ad1) au nœud N est négative. Nous rappelons, à cet égard, qu'une bascule D 70 pour laquelle son entrée C 71 est sur un front montant, la sortie Sc recopie l'état de son entrée D 72.

Ainsi, si le courant Istock est supérieur au courant Iref, le signal sur l'entrée RST de la bascule D 70 impose la sortie Q à l'état bas.

A contrario, si le courant Istock est inférieur au courant Iref, Q passe en état « haut » au premier front montant de C 71, c'est-à-dire dès que la tension au nœud N passe en négatif.

De manière avantageuse, le module de commande 60 peut comprendre une porte logique OU 63 interposée entre le moyen de détermination du signe de la tension 62 et l'entrée C 71 de la bascule D 70. La sortie du moyen de détermination du signe de la tension 62 est ainsi connectée à une entrée de la porte logique OU 63. Un générateur d'amorçage 64 peut également être connecté à une seconde entrée de la porte logique OU 63, le générateur d'amorçage 64 étant adapté pour générer le démarrage du générateur d'impulsions électriques 10.

Par porte logique OU, nous entendons un circuit logique qui dès lors qu'au moins une de ses deux entrées est dans un état haut, génère un signal haut en sa sortie. Il génère un état bas dans le cas contraire.

Le générateur d'amorçage peut être une horloge.Le signal d'amorçage (un signal haut à l'entrée de la porte logique OU 63) peut être nécessaire en cas d'absence de signal de tension V(kd1) négatif.

Toujours de manière avantageuse, le module de commande 60 peut également comprendre une porte logique ET 65 interposée entre les moyens de comparaison 61 et l'entrée D 72 de la bascule D 70. la porte logique ET comprend une première entrée alimentée par les moyens de comparaison 61 et une seconde entrée alimentée par un signal ENABLE. La porte logique ET 65 alimente l'entrée D 72 de la bascule D 70, la porte logique ET 65 étant adaptée pour envoyer un signal haut à l'entrée D 72 dès lors que le courant Istock est inférieur au courant de référence Iref et que le signal ENABLE est haut également.

Par porte logique ET, nous entendons un circuit logique qui dès lors que toutes ses entrées sont simultanément dans un état haut, génère un signal haut en sa sortie. Il génère un état bas dans le cas contraire.

Un signal ENABLE « bas » permet de commander l'arrêt du générateur d'impulsions électriques 10. En effet, puisque la décharge dans le dispositif à décharge à barrière diélectrique 20 est auto-entretenue par le mode de fonctionnement du module de commande 60 et du générateur à impulsions électriques, l'utilisateur, via une commande de signal ENABLE « bas », peut commander l'arrêt des décharges.

Le signal ENABLE peut être un signal de démarrage (pour le générateur à impulsions électriques 10). Le générateur 64 peut coopérer avec le signal d'amorçage, et envoyer une impulsion (un signal haut) à l'entrée de la porte OU 63 à laquelle il est connecté au bout d'un délai d compté à partir du front montant du signal de démarrage.

La figure 11 représente un exemple de générateur de signal d'amorçage 64. Ce dernier comprend peut être réalisé avec des circuits intégrés commerciaux, ou avec des composant discrets.

Le générateur de signal d'amorçage 64 de la figure 11 peut comprendre deux entrées destinées à recevoir, respectivement, le signal émis par la sortie de la porte OU 65, et le signe de la tension V(ad1). Le générateur de signal d'amorçage 64 peut, en outre comprendre deux résistances Rg1 et Rg2, un condensateur Cg1.

Enfin, le générateur de signal d'amorçage 64 comprend une sortie S destinée à être connectée à une entrée de la porte OU 63.

Les figures 10a et 10b représentent les oscillogrammes obtenus par simulation numérique du module de commande (60), tandis que la figure 10c représente les oscillogrammes obtenus par une mise en œuvre expérimentale du générateur à impulsions électrique commandé par le module de commande 60. Plus particulièrement, la figure 10a représentent le courant Istock traversant l'inductance Lstock, le signal ENABLE et le signal de commande Sc généré par la bascule D 70 et envoyé à l'interrupteur commandé T1. Les figure 10b et 10c représentent le courant I(dbd) traversant le dispositif à décharge à barrière diélectrique 20, ainsi que la tension V(dbd) aux bornes dudit dispositif, respectivement dans le cadre d'une simulation numérique et d'une mise en œuvre expérimentale de l'invention.

Nous notons que les oscillogrammes obtenus par simulation numérique et expérimentalement sont très similaires.

Nous notons qu'à chaque créneau du signal de commande Sc correspond une impulsion du courant Istock (par exemple, l'impulsion indiquée par le repère E sur la figure 10a). L'impulsion de courant Istock est suivie d'une décharge dans la dispositif à décharge à barrière diélectrique 20 repérable sur les figures 10b et 10c par une forte variation d'amplitude de la tension V(dbd) et du courant I(dbd) mesurés aux bornes dudit dispositif 20.

Une implémentation de la topologie indiquée en figure 9, dotée en outre des éléments suivants :

- un filtre d'entrée en parallèle avec la source de tension continue 30, le filtre comprenant une capacité de 20 μF,
- une diode de suppression de surtensions en parallèle avec Lstock,
- une capacité de 470 pF entre l'anode de la diode D1 et la masse pour éliminer les pics de tension aux bornes de l'inductance Lstock dus à l'inductance de fuite du transformateur élévateur saturable Ts.

Les paramètres du convertisseur 10 sont donnés au tableau 3.

**Tableau 3**

| Paramètre | Valeur | Unité |
|---|---|---|
| Source de tension continue 30 | Tension comprise entre 10 V et 100 V | V |
| Inductance Lstock | Inductance comprise entre 15 et 50 | μH |
| Diodes, D1, D2 | Diode Schottky | |

(suite)

| Paramètre | Valeur | Unité |
|---|---|---|
| Interrupteur commandé T1 | Mosfet N | |
| Transformateur Ts | pouvant comprendre un noyau de ferrite, et délivrer une tension comprise entre 1000 V et 8000 V aux bornes de sortie de son circuit secondaire | |
| Rg1 | 10 | $\Omega$ |
| Rg2 | 1,7 | k$\Omega$ |
| Cg1 | 20 | nF |

Dans certains cas, en particulier lorsque le dispositif à décharge à barrière diélectrique consomme une grande partie de l'énergie qui lui est transférée, la tension V(ad1) descend au-dessous de sa valeur stationnaire (Vs) à la fin de la séquence 3, sans pour autant devenir négative. Dans ce cas, on peut mettre en œuvre une variante de cette stratégie de contrôle en puissance optimale qui consiste à appliquer une tension de polarisation positive Vpol sur le second comparateur de tension à la place de la masse. Dans ce cas, le signal généré sera la différence entre la tension V(ad1) et la tension de polarisation Vpol (« V(kd1)<Vpol »). Ceci permet d'assurer la fermeture de l'interrupteur commandé T1, même si V(ad1) ne prend pas de valeur négative. Dans ce cas, la commutation ne se fera pas à courant nul, mais la tension Vpol représentant une tension inférieure à Vs, les conditions de commutation forcée resteront dans une limite acceptable pour l'interrupteur commandé T1.

## REFERENCES

[1] U. Kogelschatz et al., « Dielectric-Barrier Discharges. Principle and Applications », Journal de Physique IV Colloque, 1997, 07 (C4), pp.C4-47-C4-66,
[2] EP0781078B1,
[3] Electronics Engineer's Reference Book" édité par F.F. Mazda, 2013 ISBN 1483161064,
[4] Hubert Piquet, Sounil Bhosle, Rafael Diez, and Michael V. Erofeev, "Pulsed Current-Mode Supply of Dielectric Barrier Discharge Excilamps for the Control of the Radiated Ultraviolet Power", IEEE Transactions on Plasma Science, vol. 38, no. 10, October 2010.

## Revendications

1. Générateur d'impulsions électriques (10) destiné à alimenter un dispositif à décharge à barrière diélectrique (20), le générateur (10) comprenant une inductance (Lstock) destinée à stocker une énergie fournie, pendant une phase de charge, par une source de tension continue (30) à deux bornes (A, B) d'alimentation du générateur (10), et transférer ladite énergie au dispositif à décharge à barrière diélectrique (20) pendant une phase de décharge par l'intermédiaire d'un transformateur élévateur (Ts), le générateur (10) comprenant en outre :

   - un agencement en série d'un premier (40) et d'un second (50) circuits connectés en un nœud N du générateur (10),
   - le premier circuit (40) comprenant deux branches parallèles (41, 42), l'une des deux branches (41) comprenant l'inductance (Lstock), et l'autre branche (42) comprenant, en série, une diode (D1) reliée par son anode au nœud N, et par sa cathode au circuit primaire (Ts1) du transformateur élévateur (Ts), le circuit secondaire (Ts2) du transformateur élévateur étant destiné à être connecté au dispositif à décharge à barrière diélectrique (20),
   - le second circuit (50) comprenant un interrupteur commandé (T1) dont la fermeture et l'ouverture commandent, respectivement, les phases de charge et de décharge.

2. Générateur (10) selon la revendication 1, dans lequel le second circuit (50) comprend en outre une diode (D2) électriquement connectée en série avec l'interrupteur commandé (T1), et reliée par son anode au nœud N.

3. Générateur (10) selon la revendication 1 ou 2, dans lequel le transformateur élévateur (Ts) comprend également un noyau magnétique, le générateur à impulsions électriques (10) comprend en outre le dispositif à décharge à barrière diélectrique (20), ledit dispositif à barrière diélectrique (20) comprenant un gaz adapté pour générer une décharge à barrière diélectrique dès lors qu'une tension V, supérieure à une tension de fonctionnement $V_D$ du dispositif à décharge à barrière diélectrique (20), est imposée audit dispositif (20), de sorte que la décharge à barrière diélectrique génère une première variation de flux magnétique, prédéterminée par la tension de fonctionnement $V_D$, au travers du noyau magnétique, le noyau magnétique étant dimensionné pour se saturer magnétiquement dès lors qu'une variation de flux magnétique, supérieure à la première variation de flux magnétique, le traverse.

4. Générateur (10) selon l'une des revendications 1 à 3, dans lequel le générateur (10) comprend en outre un module de commande (60) adapté pour générer un signal de commande Sc destiné à commander l'ouverture et la fermeture de l'interrupteur commandé (T1).

5. Générateur (10) selon la revendication 4, dans lequel le module de commande (60) comprend des moyens de comparaison (61) d'un courant Istock traversant l'inductance (Lstock) avec un courant de référence Iref, le signal de commande (Sc) du module de commande (60) commandant l'ouverture de l'interrupteur contrôlé (T1) dès lors que le courant Istock est supérieur au courant Iref.

6. Générateur (10) selon la revendication 5, dans lequel les moyens de comparaison (61) comprennent un premier comparateur.

7. Générateur (10) selon l'une des revendications 5 et 6, dans lequel le module de commande (60) comprend une bascule D (70) comprenant une sortie (Sc) destinée à envoyer le signal de commande Sc à l'interrupteur commandé (T1).

8. Générateur (10) selon l'une des revendications 4 à 7, dans lequel le module de commande (60) est, en outre, adapté pour générer un signal de commande Sc de fermeture de l'interrupteur commandé (T1) dès réception d'un signal externe de commande, avantageusement, le signal externe de commande est un signal d'horloge H1 en créneau, et un signal de commande Sc de fermeture est généré sur chaque front montant du signal d'horloge H1.

9. Générateur (10) selon la revendication 8 en combinaison avec la revendication 7, dans lequel le signal externe de commande est envoyé sur une entrée C (71) de la bascule D (70), la comparaison du courant Istock avec le courant de référence Iref est envoyée sur l'entrée D (72) de la bascule D (70).

10. Générateur (10) selon l'une des revendication 4 à 7, dans lequel le module de commande (60) comprend, en outre, un moyen de détermination du signe de la tension (62) au nœud N, le module de commande (60) étant adapté pour générer un signal de commande Sc commandant la fermeture de l'interrupteur commandé (T1) dès lors que la tension au nœud N est négative.

11. Générateur (10) selon la revendication 10, dans lequel le moyen de détermination du signe de la tension (62) est un second comparateur.

12. Générateur (10) selon la revendication 10 ou 11 en combinaison avec la revendication 7, dans lequel le moyen de détermination du signe de la tension (62) est connecté à l'entrée C (71) de la bascule D (70), le moyen de détermination du signe de la tension (62) étant adapté pour envoyer un état haut à l'entrée C (71) de la bascule D (70) dès lors que la tension V(ad1) au nœud N est négative.

13. Générateur (10) selon la revendication 12, dans lequel le module de commande (60) comprend une porte logique OU (63) interposée entre le moyen de détermination du signe de la tension (62) et l'entrée C (71) de la bascule D (70), la sortie du moyen de détermination du signe de la tension (62) étant connectée à une entrée de la porte logique OU (63), et un générateur d'amorçage (64) étant connecté à une seconde entrée de la porte logique OU (63), le générateur d'amorçage (64) étant adapté pour générer un état dit « haut » en entrée de la porte logique OU (63).

14. Générateur (10) selon la revendication 13, dans lequel le module de commande (60) comprend en outre une porte logique ET (65) interposée entre les moyens de comparaison (61) et l'entrée D (72) de la bascule D (70), la porte logique comprenant une première entrée alimentée par les moyens de comparaison (61) et une seconde entrée alimentée par un signal ENABLE, la porte logique ET (65) alimentant l'entrée D (72) de la bascule D (70), la porte logique ET (65) étant adaptée pour envoyer un signal haut à l'entrée D (72) dès lors que le courant Istock est inférieur au courant de référence Iref et que le signal ENABLE est haut également, et un signal ENABLE bas permettant d'arrêter le générateur d'impulsions électriques (10).


**Patentansprüche**

1.  Elektrischer Impulsgenerator (10) zum Speisen einer dielektrischen Barriere-Entladungsvorrichtung (20), wobei der Generator (10) einen Induktor (Lstock) umfasst, der ausgestaltet ist, eine Energie zu speichern, die während einer Ladephase von einer Gleichspannungsquelle (30) an zwei Versorgungsklemmen (A, B) des Generators (10) geliefert wird, und während einer Entladephase die Energie an die dielektrische Barriere-Entladungsvorrichtung (20) über einen Aufwärtstransformator (Ts) zu übertragen, wobei der Generator (10) ferner umfasst:

    - eine Reihenanordnung von einem ersten (40) und einem zweiten (50) Schaltkreis, die an einem Knoten N des Generators (10) verbunden sind, wobei
    - der erste Schaltkreis (40) zwei parallele Zweige (41, 42) umfasst, wobei einer der beiden Zweige (41) die Induktivität (Lstock) umfasst und der andere Zweig (42) in Reihe eine Diode (D1) umfasst, die mit ihrer Anode mit dem Knoten N und mit ihrer Kathode mit dem Primärkreis (Ts1) des Aufwärtstransformators (Ts) verbunden ist, wobei der Sekundärkreis (Ts2) des Aufwärtstransformators dazu bestimmt ist, mit der dielektrischen Barriere-Entladungsvorrichtung (20) verbunden zu werden,
    - der zweite Schaltkreis (50) einen gesteuerten Schalter (T1) aufweist, dessen Schließen und Öffnen die Lade- bzw. Entladephasen steuert.

2.  Generator (10) nach Anspruch 1, wobei der zweite Schaltkreis (50) ferner eine Diode (D2) aufweist, die elektrisch in Reihe mit dem gesteuerten Schalter (T1) geschaltet ist und über ihre Anode mit dem Knoten N verbunden ist.

3.  Generator (10) nach Anspruch 1 oder 2, wobei der Aufwärtstransformator (Ts) ferner einen Magnetkern umfasst, der elektrische Impulsgenerator (10) ferner die dielektrische Barriere-Entladungsvorrichtung (20) umfasst, wobei die dielektrische Barriere-Entladungsvorrichtung (20) ein Gas umfasst, das geeignet ist, eine dielektrische Barrierenentladung zu erzeugen, wenn eine Spannung V, die größer ist als eine Betriebsspannung $V_D$ der dielektrischen Barriere-Entladungsvorrichtung (20), so auf die Vorrichtung (20) aufgebracht wird, dass die dielektrische Barrierenentladung eine erste, durch die Betriebsspannung $V_D$ vorbestimmte Magnetflussänderung durch den Magnetkern erzeugt, wobei der Magnetkern so dimensioniert ist, dass er magnetisch gesättigt wird, wenn eine Magnetflussänderung, die größer als die erste Magnetflussänderung ist, durch ihn hindurchgeht.

4.  Generator (10) nach einem der Ansprüche 1 bis 3, wobei der Generator (10) ferner ein Steuermodul (60) aufweist, das geeignet ist, ein Steuersignal Sc zur Steuerung des Öffnens und Schließens des gesteuerten Schalters (T1) zu erzeugen.

5.  Generator (10) nach Anspruch 4, wobei das Steuermodul (60) Mittel (61) zum Vergleichen eines durch die Induktivität (Lstock) fließenden Stromes Istock mit einem Referenzstrom Iref aufweist, wobei das Steuersignal (Sc) des Steuermoduls (60) die Öffnung des gesteuerten Schalters (T1) steuert, sobald der Strom Istock größer ist als der Strom Iref.

6.  Generator (10) nach Anspruch 5, wobei die Vergleichsmittel (61) einen ersten Komparator umfassen.

7.  Generator (10) nach einem der Ansprüche 5 und 6, wobei das Steuermodul (60) ein D-Flip-Flop (70) mit einem Ausgang (Sc) zum Senden des Steuersignals Sc an den gesteuerten Schalter (T1) aufweist.

8.  Generator (10) nach einem der Ansprüche 4 bis 7, wobei das Steuermodul (60) ferner dazu ausgelegt ist, ein Steuersignal Sc zum Schließen des gesteuerten Schalters (T1) zu erzeugen, sobald ein externes Steuersignal empfangen wird, wobei das externe Steuersignal vorteilhafterweise ein rechteckförmiges Taktsignal H1 ist und ein Schließsteuersignal Sc bei jeder steigenden Flanke des Taktsignals H1 erzeugt wird.

9.  Generator (10) nach Anspruch 8 in Kombination mit Anspruch 7, wobei das externe Steuersignal an einen Eingang C (71) des D-Flip-Flops (70) gesendet wird, und der Vergleich des aktuellen Stroms Istock mit dem Referenzstrom Iref an den Eingang D (72) des D-Flip-Flops (70) gesendet wird.

10. Generator (10) nach einem der Ansprüche 4 bis 7, wobei das Steuermodul (60) ferner Mittel (62) zum Bestimmen des Vorzeichens der Spannung am Knoten N umfasst, wobei das Steuermodul (60) so ausgelegt ist, dass es ein Steuersignal Sc erzeugt, das das Schließen des gesteuerten Schalters (T1) steuert, sobald die Spannung am Knoten N negativ ist.

11. Generator (10) nach Anspruch 10, wobei das Mittel (62) zur Bestimmung des Vorzeichens der Spannung ein zweiter Komparator ist.

12. Generator (10) nach Anspruch 10 oder 11 in Kombination mit Anspruch 7, wobei das Spannungsvorzeichen-Bestimmungsmittel (62) mit dem C-Eingang (71) des D-Flip-Flops (70) verbunden ist, wobei das Spannungsvorzeichen-Bestimmungsmittel (62) so ausgelegt ist, dass es einen High-Zustand an den C-Eingang (71) des D-Flip-Flops (70) sendet, sobald die Spannung am Knoten N negativ ist.

13. Generator (10) nach Anspruch 12, wobei das Steuermodul (60) ein logisches ODER-Gatter (63) aufweist, das zwischen dem Spannungsvorzeichen-Bestimmungsmittel (62) und dem C-Eingang (71) des D-Flipflops (70) angeordnet ist, wobei der Ausgang des Spannungsvorzeichen-Bestimmungsmittels (62) mit einem Eingang des logischen ODER-Gatters (63) verbunden ist, und ein Zünd-Generator (64) mit einem zweiten Eingang des logischen ODER-Gatters (63) verbunden ist, wobei der Zünd-Generator (64) so ausgebildet ist, dass er einen sogenannten "High"-Zustand am Eingang des logischen ODER-Gatters (63) erzeugt.

14. Generator (10) nach Anspruch 13, wobei das Steuermodul (60) ferner ein logisches UND-Gatter (65) aufweist, das zwischen dem Vergleichsmittel (61) und dem D-Eingang (72) des D-Flip-Flops (70) angeordnet ist, wobei das logische Gatter einen ersten Eingang, der von dem Vergleichsmittel (61) gespeist wird, und einen zweiten Eingang aufweist, der von einem ENABLE-Signal gespeist wird, wobei das logische UND-Gatter (65) den D-Eingang (72) des D-Flipflops (70) speist, wobei das logische UND-Gatter (65) so ausgelegt ist, dass es ein High-Signal an den D-Eingang (72) sendet, sobald der Strom Istock niedriger ist als der Referenzstrom Iref ist und das ENABLE-Signal ebenfalls High ist, wobei ein Low-ENABLE-Signal erlaubt, den elektrischen Impulsgenerator (10) anzuhalten.


**Claims**

1. Electrical pulse generator (10) intended to power a dielectric-barrier discharge device (20), the generator (10) comprising an inductor (Lstock) intended to store energy that is delivered, during a charge phase, by a DC voltage source (30) to two power supply terminals (A, B) of the generator (10), and to transfer said energy to the dielectric-barrier discharge device (20) during a discharge phase by the intermediary of a step-up transformer (Ts), the generator (10) further comprising:

   - an arrangement of a first (40) and of a second (50) circuits in series that are connected at a node N of the generator (10),
   - the first circuit (40) comprising two parallel branches (41, 42), one of the two branches (41) comprising the inductor (Lstock), and the other branch (42) comprising, in series, a diode (D1) connected by its anode to the node N, and by its cathode to the primary circuit (Ts1) of the step-up transformer (Ts), the secondary circuit (Ts2) of the step-up transformer being intended to be connected to the dielectric-barrier discharge device (20),
   - the second circuit (50) comprising a controlled switch (T1) of which the closing and the opening control, respectively, the charge and discharge phases.

2. Generator (10) according to claim 1, wherein the second circuit (50) further comprises a diode (D2) electrically connected in series with the controlled switch (T1), and connected by its anode to the node N.

3. Generator (10) according to claim 1 or 2, wherein the step-up transformer (Ts) also comprises a magnetic core, the electrical pulse generator (10) further comprises the dielectric-barrier discharge device (20), said dielectric-barrier device (20) comprising a gas that is suitable for generating a dielectric-barrier discharge when a voltage V, greater than an operating voltage $V_D$ of the dielectric-barrier discharge device (20), is imposed on said device (20), in such a way that the dielectric-barrier discharge generates a first variation in the magnetic flux, predetermined by the operating voltage $V_D$, through the magnetic core, the magnetic core being dimensioned to magnetically saturate when a variation in the magnetic flux, greater than the first variation in the magnetic flux, passes through it.

4. Generator (10) according to one of claims 1 to 3, wherein the generator (10) further comprises a control module (60) suitable for generating a control signal Sc intended to control the opening and the closing of the controlled switch (T1).

5. Generator (10) according to claim 4, wherein the control module (60) comprises means for comparing (61) a current Istock passing through the inductor (Lstock) with a reference current Iref, the control signal (Sc) of the control module (60) controlling the opening of the controlled switch (T1) when the current Istock is greater than the current Iref.

6. Generator (10) according to claim 5, wherein the means for comparing (61) comprise a first comparator.

7. Generator (10) according to one of claims 5 and 6, wherein the control module (60) comprises a flip-flop D (70) comprising an output (Sc) intended to send the control signal Sc to the controlled switch (T1).

8. Generator (10) according to one of claims 4 to 7, wherein the control module (60) is, furthermore, suitable for generating a control signal Sc for closing the controlled switch (T1) when an external control signal is received, advantageously, the external control signal is a clock signal H1 with timeslot, and a control signal Sc for closing is generated on each rising edge of the clock signal H1.

9. Generator (10) according to claim 8 in combination with claim 7, wherein the external control signal is sent to an input C (71) of the flip-flop D (70), the comparison of the current Istock with the reference current Iref is sent to the input D (72) of the flip-flop D (70).

10. Generator (10) according to one of claims 4 to 7, wherein the control module (60) comprises, furthermore, a means for determining the sign of the voltage (62) at the node N, the control module (60) being suitable for generating a control signal Sc that controls the closing of the controlled switch (T1) when the voltage at the node N is negative.

11. Generator (10) according to claim 10, wherein the means for determining the sign of the voltage (62) is a second comparator.

12. Generator (10) according to claim 10 or 11 in combination with claim 7, wherein the means for determining the sign of the voltage (62) is connected to the input C (71) of the flip-flop D (70), the means for determining the sign of the voltage (62) being suitable for sending a high state to the input C (71) of the flip-flop D (70) when the voltage V(ad1) at the node N is negative.

13. Generator (10) according to claim 12, wherein the control module (60) comprises a logic OR gate (63) interposed between the means for determining the sign of the voltage (62) and the input C (71) of the flip-flop D (70), the output of the means for determining the sign of the voltage (62) being connected to an input of the logic OR gate (63), and a priming generator (64) being connected to a second input of the logic OR gate (63), the priming generator (64) being suitable for generating a so-called "high" state at the input of the logic OR gate (63).

14. Generator (10) according to claim 13, wherein the control module (60) further comprises a logic AND gate (65) interposed between the means for comparing (61) and the input D (72) of the flip-flop D (70), the logic gate comprising a first input supplied by the means for comparing (61) and a second input supplied by an ENABLE signal, the logic AND gate (65) supplying the input D (72) of the flip-flop D (70), the logic AND gate (65) being suitable for sending a high signal to the input D (72) when the current Istock is less than the reference current Iref and the ENABLE signal is high also, and a low ENABLE signal that makes it possible to stop the electrical pulse generator (10).

FIG. 1

FIG. 2

A

I(Lstock)

N

B

# FIG. 3a

A

I(Lstock)

N

I(dbd)

DBD

v(dbd)

B

# FIG. 3b

A

Lstock

N

I(dbd)

# FIG. 3c

B

A

I(Lstock)

N

I(dbd)

# FIG. 3d

B

FIG. 4a

FIG. 4b

FIG. 5a

FIG. 5b

EP 3 504 795 B1

FIG. 6a

FIG. 6b

EP 3 504 795 B1

FIG. 7

FIG. 8a

FIG. 8b

EP 3 504 795 B1

FIG. 8c

EP 3 504 795 B1

FIG. 9

FIG. 10a

FIG. 10b

EP 3 504 795 B1

FIG. 10c

64

Pret

V(ad1) <0

OUrg

64

Rg2

Rg1

Cg1

S

# FIG. 11

S2

# FIG. 12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2389047 A1
- EP 0781078 B1

**Littérature non-brevet citée dans la description**

- **U. KOGELSCHATZ et al.** Dielectric-Barrier Discharges. Principle and Applications. *Journal de Physique IV Colloque,* 1997, vol. 07 (C4), C4-47, C4-66
- Electronics Engineer's Reference Book. 2013
- **HUBERT PIQUET ; SOUNIL BHOSLE ; RAFAEL DIEZ ; MICHAEL V. EROFEEV.** Pulsed Current-Mode Supply of Dielectric Barrier Discharge Excilamps for the Control of the Radiated Ultraviolet Power. *IEEE Transactions on Plasma Science,* Octobre 2010, vol. 38 (10